(19) Europäisches Patentamt
European Patent Office
Office européen des brevets

(11) **EP 2 551 685 A1**

(12) **EUROPEAN PATENT APPLICATION**

(43) Date of publication:
**30.01.2013 Bulletin 2013/05**

(51) Int Cl.:
***G01R 31/06*** (2006.01)    ***G01R 31/34*** (2006.01)

(21) Application number: **11175193.9**

(22) Date of filing: **25.07.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Fundació CTM Centre Tecnològic 08242 Manresa (ES)**

(72) Inventors:
• **Cusidó Roura, Jordi 08242 MANRESA (ES)**

• **Cárdenas Aráujo, Juan José 08242 Manresa (ES)**
• **Romeral Martínez, José Luis 08242 Manresa (ES)**
• **García Espinosa, Antoni 08242 Manresa (ES)**

(74) Representative: **Ponti Sales, Adelaida Oficina Ponti C. Consell de Cent, 322 08007 Barcelona (ES)**

(54) **Diagnostic system and method for failures in electromechanical actuators**

(57)    The system for diagnosing faults in electromechanical actuators, said electromechanical actuator comprising a motor provided with a casing and connection cables, and a mechatronic chain, is characterized in that it comprises: means for acquiring data from said electromechanical actuator; means for calculating said data for obtaining indicators; means for reducing said indicators; and means for classifying said indicators in diagnostic layers.

The method for diagnosing faults in electromechanical actuators, is characterized in that it comprises the following steps: acquiring data from said electromechanical actuator; calculating said data for obtaining indicators; reducing said indicators; and classifying said indicators in diagnostic layers.

EP 2 551 685 A1

**Description**

The present invention refers to a system for detecting faults in mechatronic chains based in the multi-dimensional analysis.

The diagnostic method is based in the multi-dimensional analysis (different input signals: currents, vibrations, voltages...), the optimization of indicators and hierarchical collaboration of specialized diagnostic algorithms. The method can diagnose multiple fault conditions of different nature, and present individually or in a combined way in an electromechanical actuator. The actuator is typically represented by an assembly of a motor and mechanical elements (gear box and/or screw).

BACKGROUND OF THE INVENTION

A equipment has been developed that, from the acquisition of different physical magnitudes, can detect multiple kinds of faults, individually or combined to each other in a complete mechatronic chain.

There are different approached to this work, presenting equipments and methods for detecting the state of mechatronic systems.

The prior art is oriented to the fault detection which appear in the mechatronic system individually by a specific method: detecting by analysis of the stator currents the motor faults, diagnostic of mechanical system analyzing vibrations or acoustic emissions.

All these methods permit the detection of faults in the components of a mechatronic system, each separately.

The rest of the prior art assumes the multi-dimensional analysis (use of different physical magnitudes) of mechatronic systems, joining the methods previously described, to obtain a greater analysis capacity of the system and to obtain a greater diagnostic capacity in incipient conditions of the fault.

However, these systems consider the detection of a few kinds of different faults, and above all, not taking into account the appearance of different fault sources in the system hiding the diagnostic and causing an error in the state evaluation of the mechatronic system.

DESCRIPTION OF THE INVENTION

The present invention refers to a detecting system and method that can detect a great quantity of faults even assuming the individual or combined appearance of them in the mechatronic system.

This is only possible by a method by high diagnostic capacities which it is not only capable of distinguishing among a lot of fault classes, but distinguishing among faults with similar effects in the acquired signals. The diagnostic power is provided by the fusion of indicators calculated from the acquired signals, emphasizing in hidden patterns in the indicators of fault conditions and collaborating among multiple specialized diagnostic algorithms.

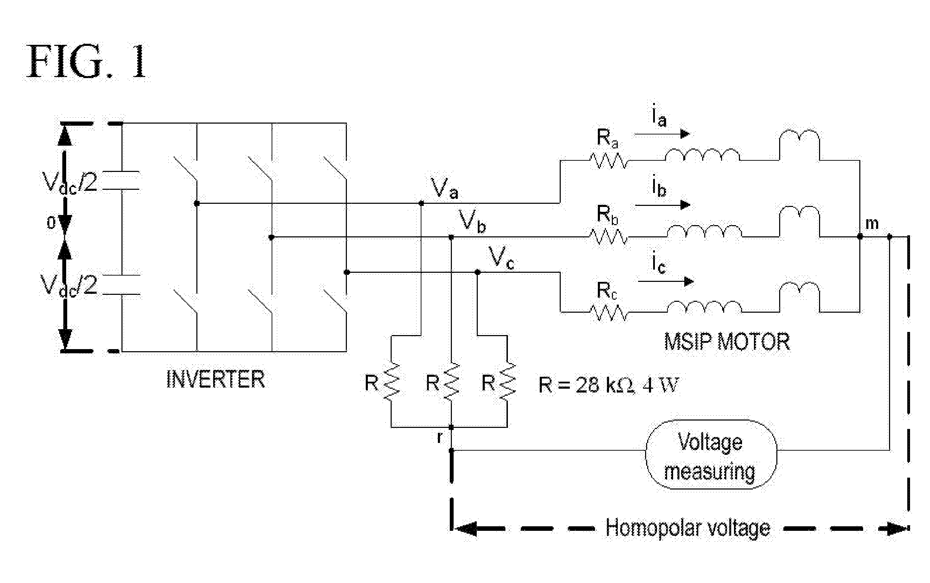

For implementing the whole system, the use of four steps is provided: acquisition, calculation, reduction and classification. In these steps techniques are integrated and information is joined, but above all, in the step of reduction and classification two new methods based in the "sequential hybrid reduction" and in "specialized hierarchical structure" are respectively applied (Fig. 1).

In the acquisition steps some physical magnitudes of the system are acquired, preferably stator currents and motor vibrations, for their complementary character reflecting electromagnetic and mechanical effects of the actuator. However, the developed system can integrate the following transducers permitting to acquire physical signal and transform it in electrical:

- Current transducer (Hall effect, Rogowski probe, Shunt...).
- Vibration transducer (accelerometer).
- Ultrasound transducer.
- Voltage transformer.

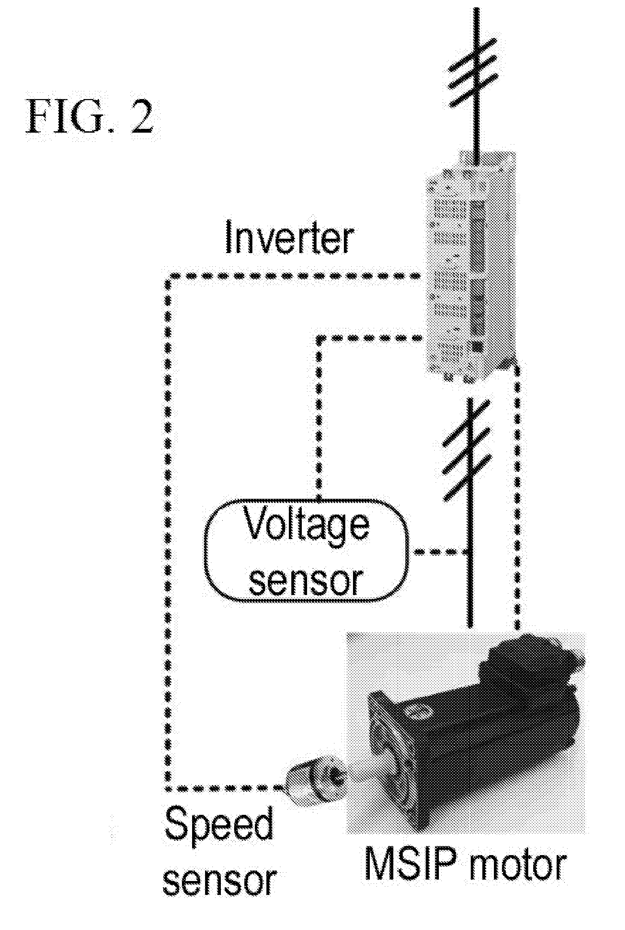

The sensors are distributed along the mechatronic chain in the following way (Fig. 2):

- Current transducer on each of the connection cables to the motor, one for each phase.
- Vibration transducer, at the motor casing on the bearing of the motor axis, a accelerator with three axis or two accelerators with one axis for acquiring the plane perpendicular to the motor axis.
- Ultrasound transducer for the acoustic emission on the motor casing and the mechatronic chain.
- Voltage transducer at the feeding phase of the motor.

Once acquired the signals, indicators are calculated in time, frequency and time-frequency during the indicator calculation step, to permit keeping the diagnostic power in stationary and non-stationary operations of the actuator (torque and speed changes). Said indicators are defined hereinafter:

- Indicators of the signals acquired on the time scope: Mean, maximum value, RMS, SRM, standard deviation, peak factor, latitude factor, impulse factor, asymmetry factor and Curtosis.
- Indicators of the signals acquired in the frequency scope: Mean, standard deviation, asymmetry factor and Curtosis.
- Indicators of the signals acquired in the time-frequency scope: The valor of the Shannon entropy of the fifteen first sub-spaces generated during the analysis by Wavelet Packet Transform of the signals, and of the six first intrinsic mode functions resulting from the analysis of the signal by Empirical Mode Decomposition.

Hereinafter the main calculated indicators are defined:

Time Statistical Indicators

Mean (T1), maximum value (T2), RMS (T3), SRM (T4), standard deviation (T5), shape factor RMS (T6), shape factor SRM (T7), peek factor (T8), latitude factor (T9), impulse factor (T10), Skewness (T11), Kurtosis (T12), 5th (T13) and 6th (T14) normalized moment.

$N$: number of samples

x: acquired signal

$i$ : integer

$$T_1 = \frac{1}{N} \sum_{i=1}^{N} x_i$$

$$T_2 = \max(x_i)$$

$$T_3 = \sqrt{\frac{\sum_{i=1}^{N}(x_i)^2}{N}}$$

$$T_4 = \left( \frac{\sum_{i=1}^{N}\sqrt{|x_i|}}{N} \right)^2$$

$$T_5 = \sqrt{\frac{\sum_{i=1}^{N}(x_i - T_2)^2}{(N-1)}}$$

$$T_6 = \frac{T_3}{\frac{1}{N}\sum_{i=1}^{N}|x_i|}$$

$$T_7 = \frac{T_4}{\frac{1}{N}\sum_{i=1}^{N}|x_i|}$$

$$T_8 = \frac{T_2}{T_3}$$

$$T_9 = \frac{T_2}{T_4}$$

$$T_{10} = \frac{T_2}{\frac{1}{N}\sum_{i=1}^{N}|x_i|}$$

$$T_{11} = \frac{\sum_{i=1}^{N}(x_i - T_2)^3}{(N-1)T_3^3}$$

$$T_{12} = \frac{\sum_{i=1}^{N}(x_i - T_2)^4}{(N-1)T_3^4}$$

$$T_{13} = \frac{\sum_{i=1}^{N}(x_i - T_2)^5}{(N-1)T_3^5}$$

$$T_{14} = \frac{\sum_{i=1}^{N}(x_i - T_2)^6}{(N-1)T_3^6}$$

Frequency Statistic Indicators

Mean of the power spectral density (F1), standard deviation of the power spectral density (F2), Skewness (F3) and Kurtosis (F4) on the power spectral density, frequency center (F5), frequency standard deviation (F6), stabilization factor (F7), variability coefficient (F8), Skewness (F9) and Kurtosis (F10) frequential.

*K* : number of frequential samples
*f* : frequency vector
*S(fᵢ)*: amplitude vector

| | |
|---|---|
| $$F_1 = \dfrac{\sum\limits_{i=1}^{K} S(f_i)}{K}$$ | $$F_1 = \sqrt{\dfrac{\sum\limits_{i=1}^{K} (S(f_i) - F_1)^2}{K-1}}$$ |
| $$F_2 = \dfrac{\sum\limits_{i=1}^{K} (S(f_i) - F_1)^2}{K F_2^3}$$ | $$F_4 = \dfrac{\sum\limits_{i=1}^{N} (S(f_i) - F_1)^4}{K F_2^4}$$ |
| $$F_5 = \dfrac{\sum\limits_{i=1}^{K} f_i S(f_i)}{\sum\limits_{i=1}^{K} S(f_i)}$$ | $$F_6 = \sqrt{\dfrac{\sum\limits_{i=1}^{N} (f_i - F_5)^2 S(f_i)}{K}}$$ |
| $$F_7 = \dfrac{\sum\limits_{i=1}^{K} f_i^2 S(f_i)}{\sqrt{\sum\limits_{i=1}^{K} S(f_i) \sum\limits_{i=1}^{K} f_i^4 S(f_i)}}$$ | $$F_8 = \dfrac{F_6}{F_5}$$ |
| $$F_9 = \dfrac{\sum\limits_{i=1}^{K} (f_i - F_5)^3 S(f_i)}{F_6^3 K}$$ | $$F_{10} = \dfrac{\sum\limits_{i=1}^{K} (f_i - F_5)^4 S(f_i)}{F_6^4 K}$$ |

Time-frequency indicators

Shannon entropy

$$F_{Hi} = -\sum_{i=1}^{I} s_i \log_2(s_i)$$

$S_i$ : The ratio between each sub-space or function of intrinsic mode and the total of the original signal. I.e. the power content of each signal.

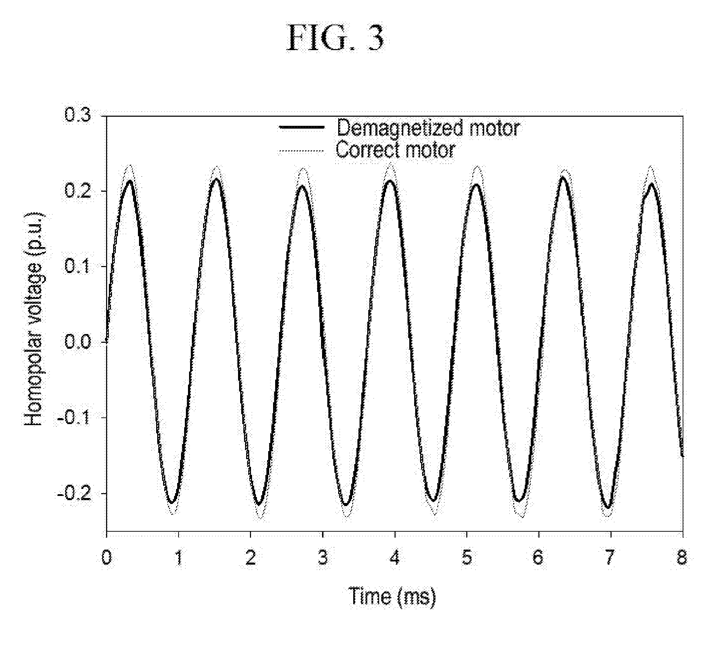

Once obtained the indicator vector containing the description of the mechatronic system, a mathematical conversion is done to remove those indicators which are not significant and/or redundant, and base change is done to emphasize the fault patterns of the system. To this end, first is applied an indicator selection technique, and then, on the result, an indicator extraction technique to obtain a sequential hybrid reduction (Fig. 3). The techniques to be used can be of any kind:

-   Selection technique: Forward selection and its variations: floating and rearwards, genetic algorithms...
-   Extraction technique: Analysis of the main components, discriminatory lineal analysis, partial square minimums...

Once the indicator vectors have been optimized, they are analyzed in a classification step, based on the collaboration of specialized algorithms. The classification step bases its differentiation capacity among multiple conditions, in a hierarchical structure of specialized classification algorithms, in specific considered conditions of the actuator and in those confusing conditions requiring a greater analysis capacity (Fig. 4).
In the first layer, specialized diagnostic algorithms coexist, each in one of the considered conditions, so that they are trained by the differentiation between a specific condition and the rest of conditions.

If the interpretation of the result of the diagnostics of all the level algorithms causes the assignation of the analyzed case to different conditions of the actuator or to none of them, it is deduced that the case to be diagnosed corresponds to a problematic case in which different conditions of the mechatronic are confused.

The same input is analyzed then in a higher level, that has been specialized during the training process only in the cases wrongly classified during the testing of the lower layer. In this layer, each classification algorithm can assume the specialization in more of a considered condition, and not necessarily all the algorithms must assume the same number of conditions.

The analysis of the results of each algorithm is interpreted again, and in an iterative way new layers can be added.

The final layer must be a single diagnostic algorithm considering all the considered classes.

For implementing the diagnostic algorithms, preferably the following methods are used:

- First layer: Support Vector Machines.
- Rest of layers: Support Vector Machine if it is desired to continue the configuration of specialized algorithms in a single condition of the actuator, or neuronal net if specialized diagnostic algorithms in more than one condition are to be implemented.

Several physical magnitudes of the system in the acquisition step are acquired, preferably stator currents and motor vibrations, for their complementary character reflecting electromagnetic and mechanical effects of the actuator. However, the developed system can integrate the following transducers permitting to acquire a physical signal and transform it in an electric one:

- Hall effect current sensors: Tecktronix A622 probes with a peak output of 100mV/A from 50mA to 100A up to a frequency of 100kHz. Hall effect current sensors on each of the connecting cables to the motor, one for each phase.
- Vibration sensors (three-axis accelerometer) for acquiring the two axes forming the plane perpendicular to the motor axis. ENDEVCO Isotron KS943B.100 sensors with standard output IEPE and a lineal response from 0,5Hz to 22kHz up to 60g. Vibration sensors in the motor casing on bearings of the motor axis, a three-axis accelerometer for acquiring the plane perpendicular to the motor axis.

Acquisition of the stator current. Acquisition of the motor vibrations.

Acquisition frequency of 20kHz during 500 msec.

The sensors are distributed along the mechatronic chain in the following way (Fig. 2).

- Current transducer on each of the connecting cables to the motor, one for each phase.
- Vibration transducer, on the motor casing on the bearings of the motor axis, a three-axis accelerometer or two one-axis accelerometers for acquiring the plane perpendicular to the motor axis.
- Ultrasound transducer for acoustic emission on the motor casing and the mechatronic chain.
- Voltage transducer in the feeding phases of the motor.

On the 10000 samples of the acquisition.

1. Statistical indicators on time (14):

Mean, maximum value, RMS, SRM, standard deviation, RMS shape factor, SRM shape factor, peek factor, latitude factor, pulse factor, Skewness , Kurtosis , 5th and 6th normalized moment.

2. Statistical indicators on frequency (10):

Mean of the power spectral density, standard deviation of the power spectral density, Skewness and Kurtosis on the power spectral density, frequency center, frequency standard deviation, stabilization factor, variability coefficient, frequential Skewness and Kurtosis.

3. Time-frequency indicators (15+6):

On the first fifteen sub-spaces generated applying the Wavelet Packet Transform by wavelet Daubechies of tenth order, Shannon entropy is applied.

On the first six functions of intrinsic mode applying Empirical mode Decompostion, Shannon entropy is applied.

Once the indicator vector containing the state description of the mechatronic system is obtained, a mathematical conversion is done to delete those indicators which are not significant and/or redundant, and a base change is done to emphasize the fault patterns of the system. To this end, first is applied an indicator selection technique, and then, on the result, a indicator extraction technique to obtain the sequential hybrid reduction (Fig. 3). Preferably:

1. Selection technique:

Forward floating selection of indicators (SFFS, Sequential Floating Forward Selection) with an input threshold of 5% and an output threshold of 10%.

2. Extraction technique:

Principal component analysis (PCA, Principal Component Analysis) with a threshold of 0,2%.

For implementing the diagnostic algorithms, preferably the following methods are used:

- First layer:

A SVM Support Vector Machines classifier, responsible of the identification between: considered condition 1 and the rest of conditions, considered condition 2 and the rest of conditions, and successively for completing the N considered conditions with the classifiers responsible of the condition N and the rest of conditions. Configuration parameters: penalty coefficient C = 0.1 and Kernel function Radial Basis Function type.
- Rest of layers: Neuronal net for implementing robust diagnostic algorithms providing more than two classification options. Configuration parameters: A first hidden layer of 40 neurons with lineal transference functions, a second hidden layer with 30 neurons with hyperbolic sigmoidal tangent functions. Training of the neuronal net by back propagation algorithm.

BRIEF DESCRIPTION OF THE DRAWINGS

For a better understanding of what has been described some drawings are attached, in which:

Fig. 1. MSIP Motor fed by an electronic inverter. It is shown the inverter, the connections to the stator windings and the net of three balanced resistors used to generate the artificial neutral.
Fig. 2. MSIP Motor fed by the electronic inverter with the voltage and speed sensors.
Fig. 3. Wave shapes of the homopolar voltage obtained with a sane MSIP motor and with a MSIP motor with two partially demagnetized poles (with a magnetization equivalent to 75% of its original state) operating at 6000 rpm.

DESCRIPTION OF A PREFERRED EMBODIMENT

A system developed on a laboratory starts from the acquisition of the stator current and the acquisition of the motor vibrations.
It is operated at an acquisition frequency of 20kHz during 500 msec.
For the acquisition they have been used:

- Hall effect current sensors: Tecktronix A622 probes with an peek output of 100mV/A from 50mA to 100A up to a frequency of 100kHz. Hall effect sensors on each of the connecting cables to the motor, one of each phase.
- Vibration sensors (a three-axis accelerometer) for acquiring the two axes forming the plane perpendicular to the motor axis. ENDEVCO Isotron KS943B.100 sensors with IEPE standard output and a lineal response from 0,5Hz to 22kHz up to 60g. Vibration sensors, at the motor casing on the bearings of the motor axis, a three-axial accelerometer for acquiring the plane perpendicular to the motor axis.

10000 samples have been acquired, on which have been applied:

1. Time statistical indicators (14):

Mean, maximum value, RMS, SRM, standard deviation, RMS shape factor, peek factor, latitude factor, pulse factor, Skewness, Kurtosis, 5th and 6th normalized moment.

2. Frequency statistical indicators (10):

Mean of the power spectral density, standard deviation of the power spectral density, Skewness and Kurtosis on the power spectral density, frequency center, frequency standard deviation, stabilization factor, variability coefficient, frequential Skewness y Kurtosis.

3. Time-frequency indicators (15+6):

On the first fifteen sub-spaces generated applying Wavelet Packet Transform by wavelet Daubechies of tenth order Shannon entropy is applied.

On the first six functions intrinsically applying Empirical mode Decompostion Shannon entropy is applied.

Once the indicators are obtained, the selection and extraction of the not significant indicators have been done, and to this end the following techniques have been used:

1. Selection technique:

Forward floating selection of indicators (SFFS, Sequential Floating Forward Selection) with an input threshold of 5% and an output threshold of 10%.

2. Extraction technique:

Principal component analysis (PCA) with a threshold of 0.2%.

Finally, for implementing the diagnostic algorithms, the following methods are preferably used:

- First layer:

  A SVM, Support Vector Machines, classifier, responsible of identification between: Considered condition 1 and the rest of conditions, considered condition 2 and the rest of conditions, and successively for completing the N considered conditions with the classifiers responsible of the condition N and the rest of conditions. Configuration parameters: Penalty coefficient C = 0.1 and Kernel function of kind Radial Basis Function.

- Rest of layers: Neuronal net for implementing robust diagnostic algorithms providing more than two classification options. Configuration parameters: A fist hidden layer of 40 neurons with lineal transference functions, a second hidden layer with 30 neurons with functions of hyperbolic sigmoidal tangent transference. Training of the neuronal net by back propagation algorithm.

**Claims**

1. System for diagnosing faults in electromechanical actuators, said electromechanical actuator comprising a motor provided with a casing and connection cables, and a mechatronic chain, **characterized in that** it comprises:

   - means for acquiring data from said electromechanical actuator;
   - means for calculating said data for obtaining indicators;
   - means for reducing said indicators; and
   - means for classifying said indicators in diagnostic layers.

2. System for diagnosing faults in electromechanical actuators according to claim 1, wherein said means for acquiring data is a plurality of current, vibration, ultrasound and/or voltage sensors.

3. System for diagnosing faults in electromechanical actuators according to claim 2, wherein said current sensors are placed at each of the connecting cables to the motor, one for each phase.

4. System for diagnosing faults in electromechanical actuators according to claim 2, wherein said vibration sensors are placed on the motor casing on bearings of the motor axis.

5. System for diagnosing faults in electromechanical actuators according to claim 2, wherein said ultrasound sensors are placed on the motor casing and on the mechatronic chain.

6. System for diagnosing faults in electromechanical actuators according to claim 2, wherein said voltage sensors are placed on the motor feeding phases.

7. System for diagnosing faults in electromechanical actuators according to anyone of claims 2-7, wherein the sensors are the following:

- Hall effect current sensors: probes with a peek output of 100 mV/A from 50 mA to 100 A up to a frequency of 100 kHz;
- Vibration sensors: three-axis accelerometer for acquiring the two axis forming the plane perpendicular to the motor axis, particularly sensors with standard IEPE output and a lineal answer from 0.5 Hz to 22 kHz up to 60 g.

8. Method for diagnosing faults in electromechanical actuators, **characterized in that** it comprises the following steps:

- acquiring data from said electromechanical actuator;
- calculating said data for obtaining indicators;
- reducing said indicators; and
- classifying said indicators in diagnostic layers.

9. Method for diagnosing faults in electromechanical actuators according to claim 8, wherein in said reduction step the indicator selection and the indicator extraction is done, a sequential hybrid reduction being done.

10. Method for diagnosing faults in electromechanical actuators according to claim 8, wherein in said classification a specialized hierarchical structure is done, particularly in several diagnostic layers.

11. Method for diagnosing faults in electromechanical actuators according to claim 9, wherein in the selection step a sequential floating forward selection, SFFS, is done, with an input threshold of 5% and an output threshold of 10%.

12. Method for diagnosing faults in electromechanical actuators according to claim 10, wherein in the indicator extraction a principal component analysis, PCA, is done, with a threshold of 0.2%.

13. Method for diagnosing faults in electromechanical actuators according to claim 11, wherein the diagnostic layers are:

- a first layer: A SVM, Support Vector Machines, classifier, responsible of identification between: Considered condition 1 and the rest of conditions, considered condition 2 and the rest of conditions, and successively for completing the N considered conditions with the classifiers responsible of the condition N and the rest of conditions, with the configuration parameters: penalty coefficient C = 0.1 and Kernel function of kind Radial Basis Function;
- Rest of layers: Neuronal net for implementing robust diagnostic algorithms providing more than two classification options, with configuration parameters: a fist hidden layer of 40 neurons with lineal transference functions, a second hidden layer with 30 neurons with functions of hyperbolic sigmoidal tangent transference, the training of the neuronal net being by back propagation algorithm.

14. Method for diagnosing faults in electromechanical actuators according to claim 9, wherein the following indicators are used:

- Time statistical indicators: Mean, maximum value, RMS, SRM, standard deviation, RMS shape factor, peek factor, latitude factor, pulse factor, Skewness, Kurtosis, 5th and 6th normalized moment.
- Frequency statistical indicators: Mean of the power spectral density, standard deviation of the power spectral density, Skewness and Kurtosis on the power spectral density, frequency center, frequency standard deviation, stabilization factor, variability coefficient, frequential Skewness y Kurtosis.
- Time-frequency indicators: On the first fifteen sub-spaces generated applying Wavelet Packet Transform by wavelet Daubechies of tenth order Shannon entropy is applied, and on the first six functions intrinsically applying Empirical mode Decompostion Shannon entropy is applied.

FIG. 1

# FIG. 2

Inverter

Voltage sensor

MSIP motor

Speed sensor

FIG. 3

Europäisches
Patentamt

European
Patent Office

Office européen
des brevets

**EUROPEAN SEARCH REPORT**

Application Number

EP 11 17 5193

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EDWARD BALABAN ET AL: "A diagnostic approach for electro-mechanical actuators in aerospace systems", AEROSPACE CONFERENCE, 2009 IEEE, IEEE, PISCATAWAY, NJ, USA, 7 March 2009 (2009-03-07), pages 1-13, XP031450246, ISBN: 978-1-4244-2621-8 * the whole document * | 1-14 | INV. G01R31/06 G01R31/34 |

-----

TECHNICAL FIELDS
SEARCHED (IPC)

G01R

The present search report has been drawn up for all claims

| Place of search | Date of completion of the search | Examiner |
|---|---|---|
| Munich | 9 December 2011 | Dogueri, Kerem |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)